Europäisches Patentamt

European Patent Office

Office européen des brevets

(19)

(11) **EP 1 170 866 A2**

(12) **EUROPEAN PATENT APPLICATION**

(43) Date of publication:
**09.01.2002 Bulletin 2002/02**

(51) Int Cl.7: **H03K 19/003**

(21) Application number: **01304680.0**

(22) Date of filing: **30.05.2001**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **05.06.2000 US 586806**<br><br>(71) Applicant: **Lockheed Martin Corporation**<br>**Bethesda, MD 20817 (US)**<br><br>(72) Inventors:<br>• **Bogorad, Alexander**<br>**Bedminster, New Jersey 07921 (US)** | • **Herschitz, Roman**<br>**Plainsboro, New Jersey 08536 (US)**<br>• **Renna, Todd Gregory**<br>**Cherry Hill, New Jersey 08002 (US)**<br>• **Sauers, James Daniel**<br>**Holland, Pennsylvania 18966 (US)**<br><br>(74) Representative: **Smith, Samuel Leonard**<br>**J.A. Kemp & Co., 14 South Square, Gray's Inn**<br>**London WC1R 5LX (GB)** |

(54) **Comparator with duplex architecture for single event upset protection**

(57)     A circuit and method to mitigate the effects of single event upset phenomenon. The circuit includes a logic gate connected to provide a fault output only when inputs by comparators receiving the same imput signal to the logic gate are all in the fault state. The method compares the outputs of comparators susceptible to single event upset phenomenon and provides a fault output only when all comparators are in a fault condition.

Figure 5

EP 1 170 866 A2

**Description**

The increased density of semiconductor device circuitry together with the increased number of spacecraft electronic system, results in an increase in the incidence of the Single Event Upset (SEU) phenomenon. This phenomenon has significant impact on spacecraft electronics. The major cause of single event upsets is high energy impacting a semiconductor device, commonly in the form of high-energy particles. These high-energy particles include heavy cosmic ray ions. Cosmic rays can affect electronic devices in a variety of ways, such as frequency shifts in frequency amplifiers, bit changes in digital devices, missing or double pulses in pulse width modulators. These unwanted effects of cosmic rays can cause upsets in spacecraft components, which in turn, can lead to on-orbit spurious shut-offs, loss of communications traffic or, in extreme cases, to the loss of the mission.

It is an object of the present invention to avoid the above-noted problems in the prior art.

It is another object of the present invention to reduce the effects of the single event upset phenomenon on semiconductor circuitry.

It is a further object of the present invention to reduce the effects of the single event upset phenomenon on protection semiconductor circuitry in a low cost and compact manner. To achieve the above and other object, the present invention provides a single event upset mitigation circuit comprising a first circuit including a first output with normal and fault states; a second circuit including a second output with normal and fault states; and a logic gate including a first input operatively coupled to the first output and a second input operatively coupled to the second output, and including an output having a fault state when the first and second outputs are the fault state.

The present invention also provides a method of mitigating single event upset in first and second circuits having respective outputs with normal and fault states, comprising: receiving an output from the first circuit; receiving an output from the second circuit; comparing the outputs of the first and second circuits; and providing a fault output only when the outputs of the first and second circuits are the fault state.

The invention will be more clearly understood from the following description, given by way of example only, with reference to the accompanying drawings, in which:

Figure 1 is a schematic diagram of a typical protection circuit that is susceptible to single event phenomenon.
Figure 2 is a waveform that graphically depicts a typical response of common semiconductor device.
Figure 3 includes waveforms depicting the effect of cosmic rays on the common device shown in Figure 4.
Figure 4 is a schematic block diagram of a typical semiconductor device including four-devices.
Figure 5. is a schematic diagram of an embodiment of the present invention.
Figure 6. is a schematic diagram of another embodiment the present invention.

The present invention provides a circuit and technique that reduces the effects of single event upset phenomenon on circuitry, and in particular semiconductor circuitry. As an illustrative example of the present invention, the following describes the present invention as applied to a common protection circuit, which is one of the most common circuits used circuits, particularly in space electronics. This circuit is used in a wide variety of electronic components such as solid state power amplifiers, power supplies, digital circuits, and travelling wave tube amplifiers.

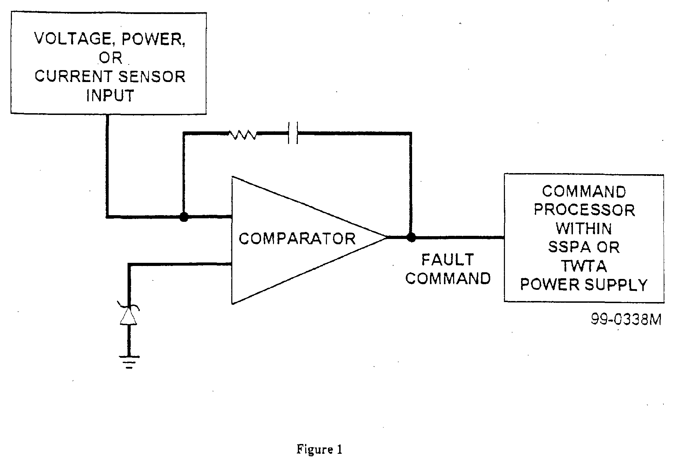

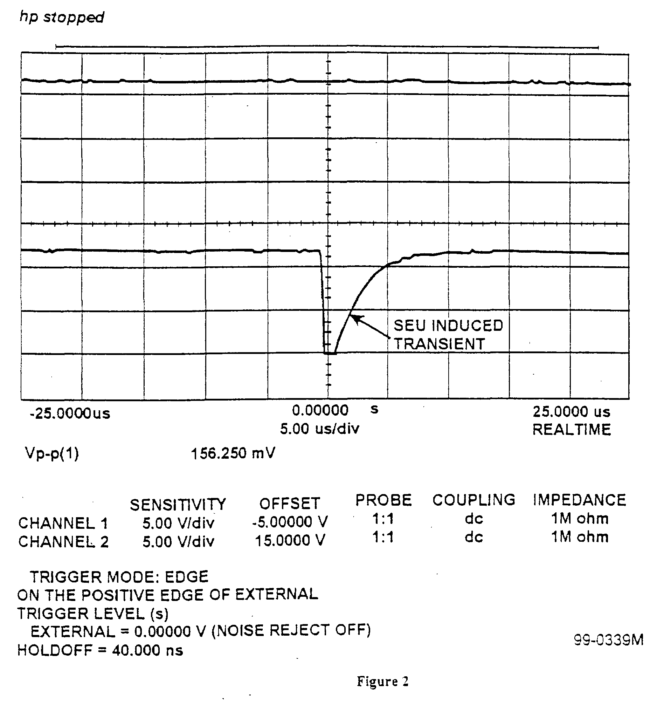

Figure 1 is a schematic diagram of a typical protection circuit that is susceptible to single event phenomenon. This figure shows a typical electronic protection circuit that is susceptible to SEU. This versatile circuit has applications for many common circuit conditions, including by way of example, power-on reset, over current protection , and overpower or over voltage protection . Commonly, these conditions result in a shut off the power supply to a circuit, or a power-on reset for digital components so as to protect the rest of the electronic components. since the above example conditions such as over current or over voltage have very short but devastating effects, the protection circuit is typically based on fast-acting comparator such as LM139 or other similar devices. This is because the circuit protection or circuit shut off has to occur almost instantaneously (< 5 microseconds) in order to provide required protection. However, the fast reaction time of a protection circuit causes it to be highly susceptible to the single event upset phenomenon that can be induced by cosmic rays. Tests have demonstrated that comparators are susceptible to Single Event Upsets. As mentioned above, such upsets occur when a device is hit with high energy such as when heavy ions or high-energy protons hit the device. As a result of such hit, the semiconductor material in the device junction is ionized and this causes the comparator to momentarily falsely turn on or to shut off without fault condition actually occurring. The resultant voltage transient of the circuit is shown in Figure 2. Such a cosmic ray induced transient is interpreted by the electronics as a shut off command. This, in turn, causes the electronic component that is protected by this circuit to shut off. Because the protection circuit has to be fast acting, this SEU transient can not be filtered since it would slow down the circuit response and render it useless during real fault condition.

For large communications satellite systems with multiple transponders (e.g., up to a 100) this can result in 50 shut offs per year and this, in turn, results in up to 50 associated communication losses per year. Such upset rates are unacceptably high, because it leads to the loss of communications for significant period of time ranging from 10 minutes to potentially several hours. This loss of communications, in turn, results in significant revenue loss for the companies carrying the signal because it interrupts TV and radio broadcasts, pager services and mobile communications. Therefore, new large communications spacecraft require reliable mitigation methods that will not degrade basic circuit performance and communications system performance; the mitigation design must also have a minimal weight and power impact. The following describes embodiments of a novel single event upset immune circuit design.

In a preferred embodiment, the present invention utilizes a combination of an additional comparator in conjunction with a logic family device gate (e.g., NAND or NOR). This configuration mitigates a circuit's single event effects ('SEE') and makes the design immune to SEU phenomenon. The illustrated embodiment uses a second comparator and combines the outputs from both comparator devices using a NAND gate or a NOR gate. This insures that a false signal can only occur if both comparators are upset simultaneously. This is due to the nature of the operation of digital logic devices, which provide an output only when both inputs are "low" (NOR gates) or "high" (NAND gate) - see logic Tables 1 and 2 below.

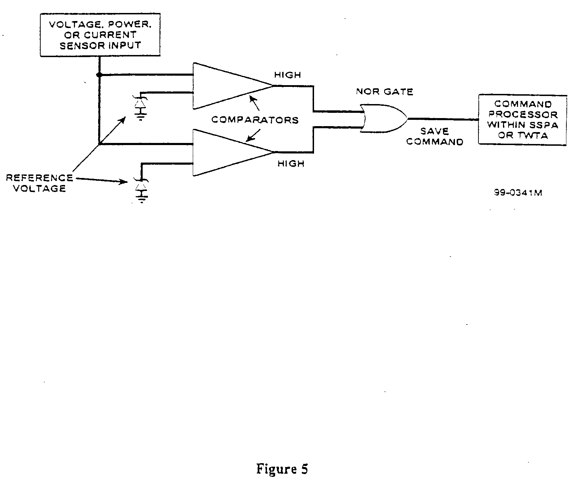

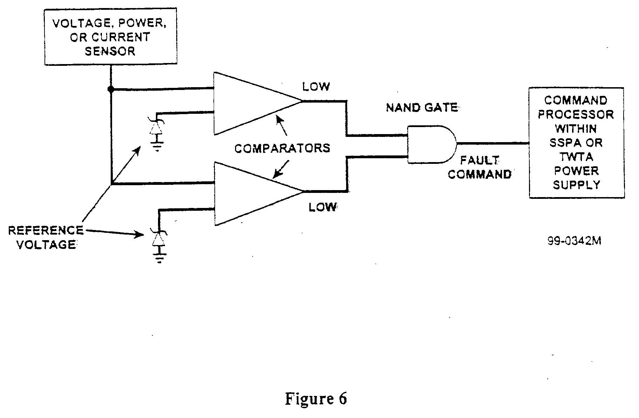

We have demonstrated that both comparators can not be upset simultaneously when exposed to a heavy ion environment. Specifically, test results showed that exposing four devices to a worst-case environment does not result in any simultaneous triggers. In these tests, circuits that included modifications shown in Figures 5 and 6 were tested at Brookhaven National Laboratory Tandem Van de Graaff Generator Facility. Circuits such as shown in Figure 1 were also tested. During the test, circuits were placed in vacuum chamber (P=10E-6 torr) and exposed to the range of heavy ions representative of 20 years of geosynchronous space environment exposure to galactic cosmic rays and solar flare heavy ions.

Circuits were exposed to the following ions types and fluences:

1. Li - LET = 0.4, F=10E6 #/cm2
2. F - LET = 3.3, F-10E6 #/cm2
3. Si - LET = 7.5, F=10E6 #/cm2
4 Cl- LET = 11.1, F=10E6 #/cm2
5. Ti - LET = 18.0, F=10E6 #/cm2
6. Fe - LET = 24.1, F=10E6 #/cm2
7. Ni - LET = 26.2, F=10E6 #/cm2
8. Br-LET=36.8, F=10E6 #/cm2
9. Ag- LET = 52.7, F=10E6 #/cm2
10. Au-LET = 83.9, F=10E6 #/cm2
      LET is in MeV.cm2/mg.

During exposure the outputs of each of the three circuits as well as the output of each of the comparators were monitored for the upsets with a computer controlled digitizing oscilloscope. This recorded and continuously stored all the transients that occurred at the outputs of each of the three circuits.

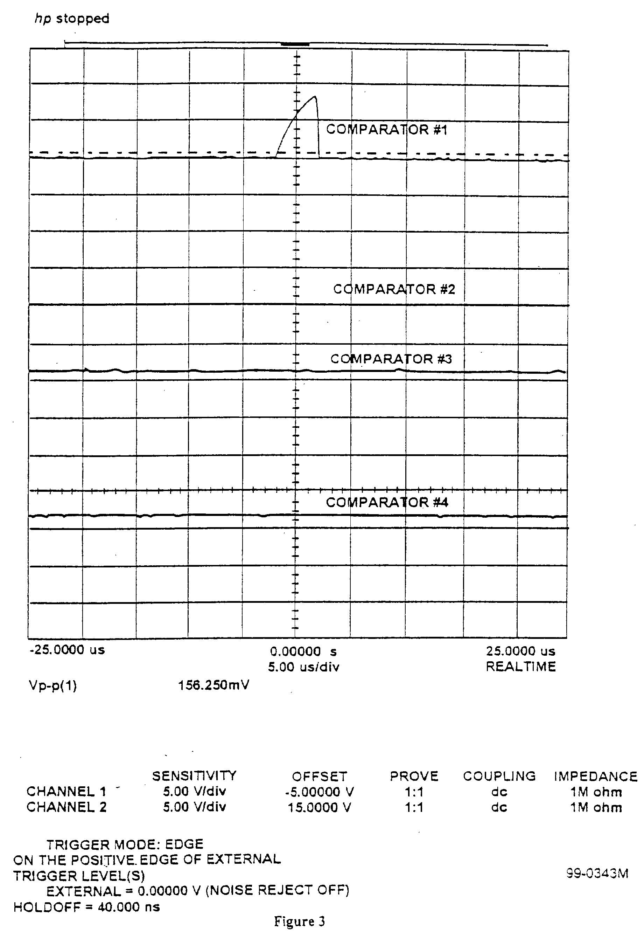

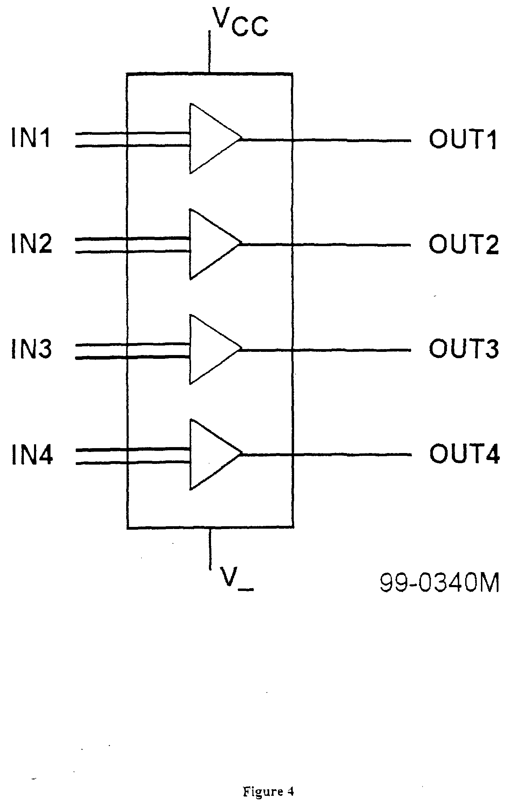

The results showed that original circuit (Figure 1) was susceptible to frequent upsets. Figure 2 is a waveform that graphically depicts a typical response of the tested semiconductor device. Such response, in its actual application, would result in unacceptable hardware performance. Similarly, frequent upsets were observed at the output of each of the individual devices for the modified circuits. However, since no two of these upsets had occurred simultaneously on any of the two devices (Figure 3), no transients were observed at the output of the circuits that included SEU modification. Figure 3 includes waveforms depicting the effect of cosmic rays on the common device shown in Figure 4. More particularly, Figure 3 shows the simultaneous response of four devices in the same package when exposed to cosmic rays. It demonstrates that no two devices were upset simultaneously, thus insuring that the inputs to the logic family device do not change state as a result of SEU event. This demonstrates that circuits in accordance with the present invention are immune to single event upsets.

The addition of extra comparator and either a NAND gate or a NOR gate does not result in either any significant weight or power increase. One reason for this is that comparators typically come with 4 devices per single package a shown in Figure 4. Furthermore, most designs usually have redundant devices such as LM139 or NAND gates already available on a typical circuit board. Also many NOR and NAND gates from various vendors are themselves immune to single event upset. Two implementations of such circuit are shown in Figures 5 and 6.

Using an additional comparator and a NAND gate or a NOR gate reduces the probability of false shut offs from 0.5 upsets/device/year to less than one upset per 1000 years. The typical circuit-upset rates are calculated using standard industry accepted methodology using the following expression:

$$R = 365 \times 200 \; \sigma/L^2 \text{ (upsets/device/year)} \qquad \text{Equation 1}$$

Where R is an upset rate, σ - upset saturation cross section and L is the linear energy transfer at 25% of saturation. These parameters are determined experimentally by exposing devices to heavy ions. The parameter σ - shows how many upsets will occur per incident ion and is an indicator of device sensitivity to cosmic rays. The parameter L - characterizes an ion's ability to deposit energy into a device. The larger the value of L, the lower is the possibility that ion will induce the upset.

For the original circuit the average upset rate is equal to R= 0.5 upsets/device/year. The values of σ and L are $4.3 \times 10^{-4}$ and 8, respectively.

The upset rate of the modified circuit is $R < 10^{-5}$ upsets/device/year or less than one upset per 1,000 years. The values of σ and L are $σ < 10^{-6}$ and 83, respectively.

The following generally describes the logic circuitry utilized in the embodiments of the present invention. Logic gate input terminals are in either High or Low state by applying appropriate voltages to them; then the output terminals are in High or Low state, depending on the logic function performed. Only two voltage levels are allowed at the terminals of digital logic gates -- one that represents a "Low" voltage, and one that represents a "High" voltage.

The operation of a logic gate is defined by a "truth table" which relates the voltage level at the output terminal to the voltage levels at the input terminals. The truth table for a NOR gate is given below.

Table 1.

| Truth table for a NOR gate | | |
| --- | --- | --- |
| A | B | C |
| Low | Low | High |
| Low | High | Low |
| High | Low | Low |
| High | High | Low |

The output of a NOR gate is Low when input A or B (or both) is High. The output is High when inputs A and B are Low.

The single event upset circuit shown in Figure 5 and its operation is described below. The basic function of the NOR gate is as follows. For protection circuits that are configured such that in the normal condition both comparator outputs are High and no signal is generated at the output of the circuit at the NOR gate (output is Low). For this circuit, the indication of the true fault condition would by high state at the output of the NOR gate. If any of the two comparators are upset by SEU such that it's output goes Low, this has no impact on the NOR gate output because second comparator output is still high since the do not upset simultaneously. In case of true fault condition, both comparator output are puled low and NOR gate output changes state to High, issuing the True Fault signal.

The following describes an embodiment of the present invention utilizing a NAND gate. The truth table for a NAND gate is given below.

Table 2.

| Truth table for a NAND gate | | |
| --- | --- | --- |
| A | B | C |
| Low | Low | High |
| Low | High | High |
| High | Low | High |
| High | High | Low |

If inputs A and B are High, the output is Low. If inputs A AND B are High, the output is Low.

The operation of the circuit shown in Figure 6 is described below. The basic function of the NAND gate is as follows. For protection circuits that are configured such that in the normal condition both comparator outputs are Low and signal is generated at the output of the circuit at the NAND gate (output is High) indicating No Fault condition. For this circuit, the indication of the true fault condition would by Low state at the output of the NAND gate. If any of the two comparators is upset by SEU such that it's output goes High, this has no impact on the NAND gate output because the second comparator output is still high since both of them do not upset simultaneously. In case of true fault condition, both comparator outputs are puled High and NAND gate output changes state to Low, issuing the True Fault signal.

The above describes a novel approach to protecting and mitigating the effects of single event upsets due to, for example, cosmic rays. The present invention insures single event upset immunity of a circuit design, and will prevent uncommanded on-orbit cosmic ray-induced shut offs of protected circuits and equipment. Consequently, in the case of utilizing the present invention in spacecraft, the loss of communications traffic and associated revenue losses can be eliminated.

**Claims**

1. A single event upset mitigation circuit comprising:

   a first circuit including a first output with normal and fault states;
   a second circuit including a second output with normal and fault states; and
   a logic gate including a first input operatively coupled to the first output and a second input operatively coupled to the second output, and including an output having a fault state when the first and second outputs are the fault state.

2. A single event upset mitigation circuit according to claim 1, wherein the first and second circuits comprise respective comparators.

3. A single event upset mitigation circuit according to claim 1 or 2, wherein the logic gate comprises an NAND logic gate.

4. A single event upset mitigation circuit according to claim 1 or 2, wherein the logic gate comprises a NOR logic gate.

5. A method of mitigating single event upset in first and second circuits having respective outputs with normal and fault states, comprising:

   receiving an output from the first circuit;
   receiving an output from the second circuit;
   comparing the outputs of the first and second circuits; and
   providing a fault output only when the outputs of the first and second circuits are the fault state.

6. A method of mitigating single event upset according to claim 5, wherein the comparing includes performing a logical NAND operation on the outputs of the first and second circuits.

7. A method of mitigating single event upset according to claim 5, wherein the comparing includes performing a logical NOR operation on the outputs of the first and second circuits.

Figure 1

99-0338M

*hp stopped*

SEU INDUCED TRANSIENT

-25.0000us                    0.00000    s              25.0000 us
                             5.00 us/div                 REALTIME

Vp-p(1)                156.250 mV

|  | SENSITIVITY | OFFSET | PROBE | COUPLING | IMPEDANCE |
|---|---|---|---|---|---|
| CHANNEL 1 | 5.00 V/div | -5.00000 V | 1:1 | dc | 1M ohm |
| CHANNEL 2 | 5.00 V/div | 15.0000 V | 1:1 | dc | 1M ohm |

TRIGGER MODE: EDGE
ON THE POSITIVE EDGE OF EXTERNAL
TRIGGER LEVEL (s)
  EXTERNAL = 0.00000 V (NOISE REJECT OFF)
HOLDOFF = 40.000 ns

99-0339M

Figure 2

7

*hp* stopped

COMPARATOR #1

COMPARATOR #2

COMPARATOR #3

COMPARATOR #4

-25.0000 us

0.00000 s
5.00 us/div

25.0000 us
REALTIME

Vp-p(1)                156.250mV

|  | SENSITIVITY | OFFSET | PROVE | COUPLING | IMPEDANCE |
|---|---|---|---|---|---|
| CHANNEL 1 | 5.00 V/div | -5.00000 V | 1:1 | dc | 1M ohm |
| CHANNEL 2 | 5.00 V/div | 15.0000 V | 1:1 | dc | 1M ohm |

TRIGGER MODE: EDGE
ON THE POSITIVE EDGE OF EXTERNAL
TRIGGER LEVEL(S)
    EXTERNAL = 0.00000 V (NOISE REJECT OFF)
HOLDOFF = 40.000 ns

99-0343M

Figure 3

8

Figure 4

Figure 5

VOLTAGE, POWER, OR CURRENT SENSOR

LOW

COMPARATORS

REFERENCE VOLTAGE

LOW

NAND GATE

FAULT COMMAND

COMMAND PROCESSOR WITHIN SSPA OR TWTA POWER SUPPLY

99-0342M

Figure 6